# EUROPEAN PATENT APPLICATION

(11) **EP 1 944 652 A1**
(43) Date of publication of application: **16.07.2008**
(21) Application number: 07000471.8
(22) Date of filing: 10.01.2007
(51) Int. Cl.: G03F 7/20

(54) **A method for operating a euv lithography apparatus, and a euv lithography apparatus**

(71) Applicant: Carl Zeiss SMT AG, 73447 Oberkochen (DE)
(72) Inventor: Yakshin, Andrey E., 3432 BD Niewegein (NL); van de Kruijs, Robbert W.E., 5666 AS Geldrop (NL); Bijkerk, Fred, 1016 RD Amsterdam (NL); Louis, Eric, 3402 ZG Ijsselstein (NL)
(74) Representative: Werner, Anne-Estelle

(57) **Abstract**

The proposed EUV/SX lithography apparatus (100) allows providing an atmosphere containing atomic nitrogen inside the apparatus, in particular during operation of the lithography apparatus to avoid degradation of the reflective optical element (113,121,122,130,141,142) due to oxidation or carbon contamination. Through the nitrogen inlet (123,143) either atomic nitrogen or molecular nitrogen can be provided, the molecular nitrogen being split into atomic nitrogen by irradiation with EUV/SX radiation during operation of the apparatus. The atomic nitrogen will react with the oxygen from water dissociated by irradiation with EUV/SX radiation during operation to volatile nitrogen oxides. Depending on the surface material of the reflective optical element (113,121,122,130,141,142), the atomic nitrogen can also react with it to form a thin layer of nitride, which is often resistant against oxidation.

## Description

### Field of the invention

The present invention relates to a method for operating a lithography apparatus for the extreme ultraviolet (EUV) or soft x-ray (SX) wavelength range having a reflective optical element for the extreme ultraviolet or soft x-ray wavelength range. The present invention also relates to a method for producing a reflective optical element for the extreme ultraviolet or soft x-ray wavelength range having a multilayer structure. The present invention further relates to a lithography apparatus for the extreme ultraviolet or soft x-ray wavelength range having a reflective optical element for the extreme ultraviolet or soft x-ray wavelength range as well as to an illuminating system and a projection system having a reflective optical element for the extreme ultraviolet or soft x-ray wavelength range.

### Background and prior art

Reflective optical elements for the EUV and SX wavelength range (i.e. ca. 1 nm to 20 nm) may, for example, be multilayer mirrors. Multilayers are based on periodical stacks, whereby, in the simplest case, one period consists of two layers. The material of one of the layers should preferably show a high real part of the refractive index, while the material of the other layer should show a low real part of the refractive index. The layer with the high real part of the refractive index is also called spacer; the layer with the small real part of the refractive index is also called absorber. The thickness of the period as well as the thickness of the individual layers is chosen depending upon the operating wavelength, so that the reflectivity is maximized at this operating wavelength.

Reflective optical elements are used, for example, in EUV/SX lithography apparatuses for the production of semiconductor devices. They are commonly used for the illumination optics, the reticle and the projection optics. During operation, the reflective optical elements in a EUV lithography apparatus are exposed to a radiation of up to 20mW/mm² EUV photon density or more and to residual gases such as water, oxygen, and hydrocarbons. The residual gases are split to reactive fragments, such as e.g. oxygen radicals, which cause degradation and contamination of the multilayer surface, by irradiation with EUV/SX photons or secondary electrons or by the influence of external electrical fields. The surface damage due to oxidation or contamination by hydrocarbons reduces the reflectance of each reflective optical element. A relative reduction, for example, of 1% of each reflective optical element's reflectance reduces the total monochromatic throughput of a EUV/SX lithography apparatus with 10 reflective optical elements by 10%, which is quite significant.

It has been known in the state of the art to use a gas and radiation to produce a protective coating that is substantially void-free on the molecular scale, self-terminating, and degradation resistant. A gas is introduced into the environment of the surface to be protected. The gas comprises a molecular species that because of the presence of an appropriate functional group or groups on the molecule can adsorb or be bound directly onto the surface to be protected. Exposure to a radiation flux causes the adsorbed or bound molecular species to dissociate into reactive fragments that remain bound to the surface. Subsequently, the dissociated and reactive species couple together to form a uniform layer or film that is void-free on the molecular level. Ethanol, in particular, is used as gas.

It is one object of the present invention to provide a possibility to avoid the degradation of reflective optical elements of the EUV/SX wavelength range, in particular of reflective optical elements in a EUV/SX lithography apparatus.

### Summary of the invention

In a first aspect of the present invention, this object is achieved by a method for operating a lithography apparatus for the extreme ultraviolet or soft x-ray wavelength range having a reflective optical element for the extreme ultraviolet or soft x-ray wavelength range, wherein at least adjacent to the reflective optical element an atmosphere containing atomic nitrogen is provided.

By adding atomic nitrogen to the atmosphere inside the lithography apparatus, in particular during operation of the lithography apparatus, several positive effects are achieved. In a first instance, the nitrogen will compete with other residual gases, such as water or hydrocarbon, for room on the surface of the reflective optical element, thus reducing the probability of contamination or oxidation of the surface. The atomic nitrogen will react with the oxygen, in particular oxygen radicals, from water, that is dissociated by irradiation with EUV/SX radiation during exposure, to volatile nitrogen oxides, too. This further reduces the probability of oxidation of the surface of the reflective optical element. Depending on the surface material of the reflective optical element, the atomic nitrogen can also react with it to form a thin layer of nitride, which is often resistant against oxidation. By reducing the amount of oxygen available for oxidizing the surface of the reflective optical element and reducing the probability of carbon deposition on the surface due to residual hydrocarbons, the degradation of the reflective optical element inside the EUV/SX lithography apparatus is significantly reduced. Besides, nitrogen does not noticeably influence the operation of the lithography apparatus by e.g. absorbing some the EUV or SX radiation, unless its partial pressure is in the range of atmospheric pressure.

In a second aspect of the present invention, this object is achieved by a method for producing a reflective optical element for the extreme ultraviolet or soft x-ray wavelength range having a multilayer structure, wherein after depositing the topmost layer, the reflective optical element is exposed to an atmosphere containing atomic nitrogen.

To efficiently protect the reflective optical element, it can be exposed to atomic nitrogen already immediately after its production. Upon completion of the deposition process, possibly including a special capping layer, the vacuum system of the deposition apparatus is vented and ambient components like water, hydrocarbons or oxygen are causing physisorbed layers on the topmost layer of the reflective optical element. According to the present invention, this process is mitigated by exposing the surface of the reflective optical element to atomic nitrogen. The nitrogen is physisorbed at the fresh surface. That hinders the other components to physisorb, too, during venting. In case of an appropriate material of the topmost layer of the reflective optical element even a thin and degradation resistant nitride layer may be formed on the surface of the topmost layer. Nitrides are very stable compounds that also act as good diffusion barriers.

In a third aspect of the present invention, this object is achieved by a lithography apparatus for the extreme ultraviolet or soft x-ray wavelength range having a reflective optical element for the extreme ultraviolet or soft x-ray wavelength range that comprises a plasma source, in particular for providing atomic nitrogen.

This EUV/SX lithography apparatus allows providing an atmosphere containing nitrogen inside the apparatus, in particular during operation of the lithography apparatus to avoid degradation of the reflective optical element due to oxidation or carbon contamination.

In a fourth aspect of the present invention, this object is achieved by an illumination system for a lithography apparatus for the extreme ultraviolet or soft x-ray wavelength range having a reflective optical element for the extreme ultraviolet or soft x-ray wavelength range, characterized in that it comprises a plasma source, in particular for providing atomic nitrogen.

In a fifth aspect of the present invention, this object is achieved by a projection system for a lithography apparatus for the extreme ultraviolet or soft x-ray wavelength range having a reflective optical element for the extreme ultraviolet or soft x-ray wavelength range, characterized in that it comprises a plasma source, in particular for providing atomic nitrogen.

Preferred embodiments are described in the dependent claims.

### Brief description of the drawings

A detailed description of the invention is provided below. Said description is provided by way of a non-limiting example to be read with reference to the attached drawings in which-
- Figure 1: illustrates schematically a EUV lithography apparatus with nitrogen inlets;
- Figure 2a: illustrates schematically a multilayer mirror with nitride layer;
- Figure 2b: illustrates schematically a multilayer mirror with a capping layer and a nitride layer;
- Figure 3: shows a flowchart of a first embodiment of the method for operating a EUV/SX lithography apparatus;
- Figure 4: shows a flowchart of a second embodiment of the method for operating a EUV/SX lithography apparatus; and
- Figure 5: shows a flowchart of an embodiment of the method for producing a reflective optical element for the EUV/SX wavelength range.

### Detailed description of the invention

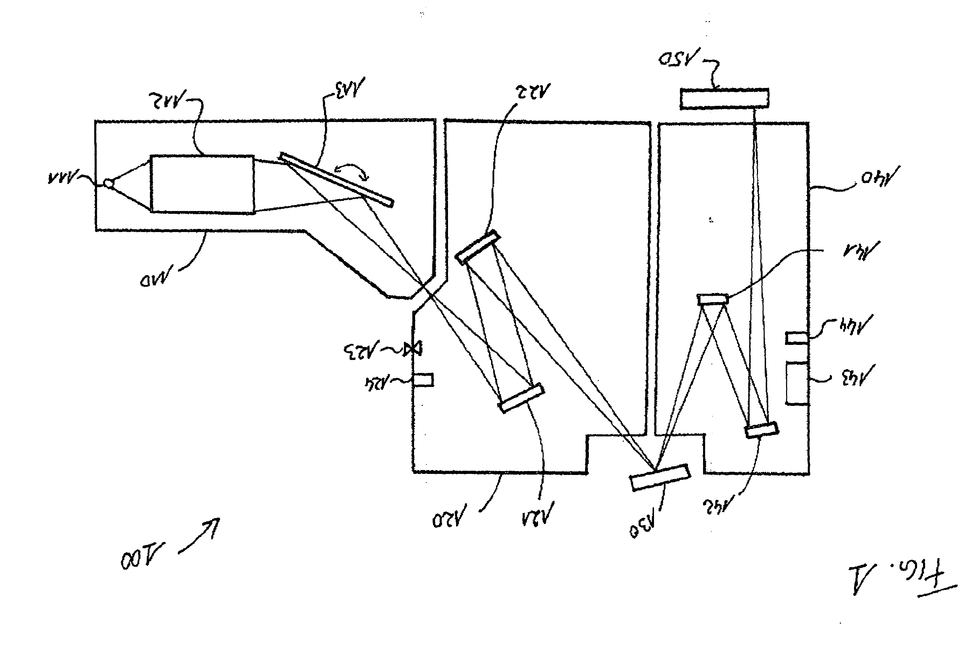

Figure 1 shows schematically a EUV lithography apparatus 100. Its main components are the beam shaping system 110, the illumination system 120, the reticle 130 and the projection system 140.

The EUV source 111 may be a plasma source or a synchrotron. The radiation of the EUV source 111 has a wavelength in the range of about 5 nm to 20 nm, In the beam shaping system 110, the radiation is collimated in the collimator 112. Then, the monochromator 113 filters the desired wavelength needed for illuminating the reticle 130 and projecting its structure onto the wafer 150 by varying the angle of incidence of the collimated beam. In the present wavelength range, normally, reflective optical elements such as multilayer mirrors are used as collimator 112 and monochromator 113 for shaping the beam with respect to wavelength and angular distribution.

The illumination system 120 illuminates the reticle 130 with the shaped beam by reflecting it in the present example with the help of two multilayer mirrors 121, 122. Depending on the specific needs, there can also be only one or three, four, five or more reflective optical elements, if needed. In the vicinity of multilayer mirrors 121, 122, an inlet 123 for molecular nitrogen is provided. Besides, a measurement module 124 is provided for measuring the partial pressures of the residual gases inside the illumination system 120 like e.g. water or hydrocarbon, and for measuring the partial pressure of molecular nitrogen as well. The partial pressure of the molecular nitrogen is chosen to be a factor of ca. 10 to 100 or higher than the partial pressures of the other residual gases, in particular water and hydrocarbons. Only in baked systems, it might be necessary to take into account the partial pressures of molecular oxygen, carbon monoxide and carbon dioxide, too. In not baked systems their partial pressures are negligible. During operation of the lithography apparatus 100, the EUV radiation splits the nitrogen molecules into atoms. The atomic nitrogen then reacts with the other residual gases or their fragments, if they are split by the EUV radiation as well. It eventually reacts with the surface of the mirrors 121, 122 to a thin nitride layer at the surface. The atomic as well as the molecular nitrogen adsorb at the surface of the mirrors 121, 122 and, thus, leave less space for the other components of the atmosphere inside the illumination system 120 to adsorb and react with or accumulate on the surface of the mirrors 121, 122.

To be useable with EUV or SX radiation, the reticle 130 is a reflective optical element, too. The beam reflected by the reticle 130, respectively the structure of the reticle 130, is projected onto the wafer 150 by the projection system 140 with the help of two multilayer mirrors 141, 142 like in the illumination system 120. As well as in the illumination system 120, there can be as well only one or three, four, five or more reflective optical elements in the projection system 140, if needed. Near to the multilayer mirrors 141, 142, an inlet 143 for atomic nitrogen is provided. The source of the atomic nitrogen is preferably a plasma source like a Kaufman source or a RF plasma source such as an electron cyclotron wave resonance source as is used in the present example. Besides, a measurement module 144 is provided for measuring the partial pressures of the residual gases inside the projection system 140 like e.g. water or hydrocarbon, and for measuring the partial pressure of the atomic nitrogen as well. The atomic nitrogen physisorbs on the surface of the mirrors 141, 142, eventually reacts with the material of their topmost layer to a thin layer of nitride at the surface, and reacts with the oxygen provided by the other components or their fragments due to EUV irradiation to volatile nitrogen oxides.

In the present example, it has been chosen to provide molecular nitrogen to the illumination system 120, where the intensity of the EUV radiation and thus the splitting rate of nitrogen is higher, and to provide immediately atomic nitrogen to the projection system 140, where the EUV radiation intensity is lower. This allows providing a lower partial pressure of nitrogen while still having a comparable number of single nitrogen atoms in the projection system 140 and the illumination system 120. Reducing the partial pressure reduces a possible absorption of EUV radiation that could lessen the intensity of the beam.

As the partial pressure of atomic nitrogen is more difficult to control than the partial pressure of molecular nitrogen, advantageously, the flux of atomic nitrogen exiting the plasma source can be taken into account. The necessary flux depends on the amount of oxygen radicals created at the surface of the reflective optical element during exposure to EUV radiation. This amount depends itself on the partial pressures of oxygen containing residual gases and on the EUV intensity. The amount of nitrogen atoms per time unit at the surface should exceed the amount of oxygen radicals created per time unit at the surface to obtain best results. This is valid as well, when providing molecular nitrogen like in the illuminating system 120.

It will be noted that it is possible to provide molecular and/or atomic nitrogen to both systems 120, 140 or to only one of the system 120, 140 or to provide atomic nitrogen to the illumination system 120 and molecular nitrogen to the projection system 140 because of e.g. the higher degradation rate in the illumination system 120. It will further be noted that the reticle 130 or the reflective optical elements in the beam shaping system 110 like the collimator 112 or the Monochromator 113 can successfully be exposed to atomic nitrogen as well to prevent surface degradation. The preferred approach will depend on the tolerances of the actual lithography process and of the components of the lithography apparatus 100.

It has been found that the atomic nitrogen will react especially well with the other residual gases or their fragments, if the pressure is so high that the mean free path of the molecules of the other residual gases becomes considerably smaller than the dimensions of the concerned part of the lithography apparatus 100, here the illuminating system 120 and the projection system 140. In the present example illustrated in Figure 1, the pressure is above ca. 5x10⁻⁴ mbar.

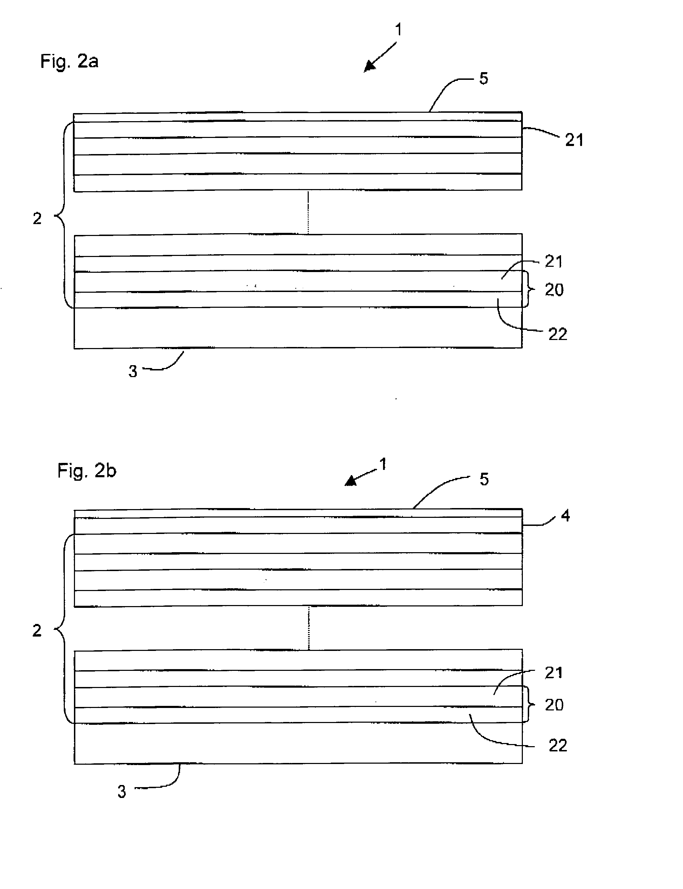

Examples of reflective optical elements for the EUV/SX wavelength range based on a multilayer structure are schematically illustrated in Figures 2a,b. A multilayer structure 2 has been deposited on a substrate 3. Eventually, there can be an additional capping layer 4 on top of the multilayer structure 2, as shown in Figure 2b, for protection of the multilayer structure, especially its surface. The capping layer may be a capping system comprising more than one layer, e.g. for optical match of the upper capping layers to the layers of the multilayer structure 2 to optimize the reflectance of the reflective optical element 1.

The multilayer structure 2 consists basically of periodic stacks 20, each including a layer 21 of a material having a higher real part of the complex refraction index (also called spacer) and a layer 22 of a material having a lower real part of the complex refraction index (also called absorber). At each interface between spacer layers 21 and absorber layers 22, part of the EUV/SX radiation is reflected. The thickness of the absorber and particularly of the spacer layers are chosen to allow for constructive interference of the reflected beam according to Bragg's Law.

It will be noted that a stack 20 may include more than two different layers and that the thicknesses of the stacks 20 may vary over the depth of the multilayer structure.

In particular for use with EUV radiation, preferably at a wavelength between around 13 nm and 14 nm, the most preferred materials are silicon for the spacer layers 21 and molybdenum for the absorber layers 22. Preferred materials for the topmost layer are silicon (see numeral 21 in Figure 2a) or ruthenium as the capping layer 4 (see Figure 2b). Other suited materials are e.g. rhodium, palladium, titanium dioxide, zirconium dioxide, hafnium dioxide, or vanadium oxide.

The impact of water or hydrocarbons in the atmosphere on particularly molybdenum/silicon multilayer mirrors with silicon as topmost layer is the following. Under standard room temperature conditions, water molecules will physisorb at the silicon surface. An equilibrium between molecular adsorption and desorption occurs, with the average coverage depending on the partial vapour pressure of the water. No chemical reaction of the water with the surface takes place, if no EUV photons are present. However, if the surface is irradiated with EUV, the water molecules are dissociated and the oxygen diffuses into the silicon layer and reacts to silicon oxide. Still present oxygen diffuses through the already existent silicon oxide layer and reacts with the underlying silicon to silicon oxide, too. This substantially degrades the optical properties of the multilayer mirror. The hydrocarbons decompose under EUV radiation to fragments that adsorb and accumulate on the topmost layer of the mirror, leading to carbon contamination. Depending on the partial pressure of water and hydrocarbons, either oxidation or carbon contamination will be predominant.

In case of the topmost layer being either silicon as in Figure 2a or ruthenium as in Figure 2b, both materials are not inert to atomic nitrogen, but react with atomic nitrogen to a thin silicon nitride layer 5 or ruthenium nitride layer 5' on the surface of the topmost layer 21, 4 of the reflective optical element 1. The nitride layer 5, 5' is in both cases more resistant against oxidation than the former layers of pure silicon or ruthenium. Besides, carbon and hydrocarbons have a low probability of adsorption and, thus, of accumulation. In consequence, carbon contamination is reduced, too. A further advantage is that the silicon nitride or the ruthenium nitride does not diffuse into the silicon or the ruthenium, respectively. Therefore, the optical characteristics of the reflective optical elements 1 are not noticeably degraded by the nitride layer 5, 5'. A possible slightly negative effect is counterweighted by the advantage of the optical characteristics being constant over a longer time, because of the reduction of surface damage due to contamination and especially oxidation, which are also avoided by the presence of atomic nitrogen in the atmosphere inside a EUV lithography apparatus as explained with respect to Figure 1.

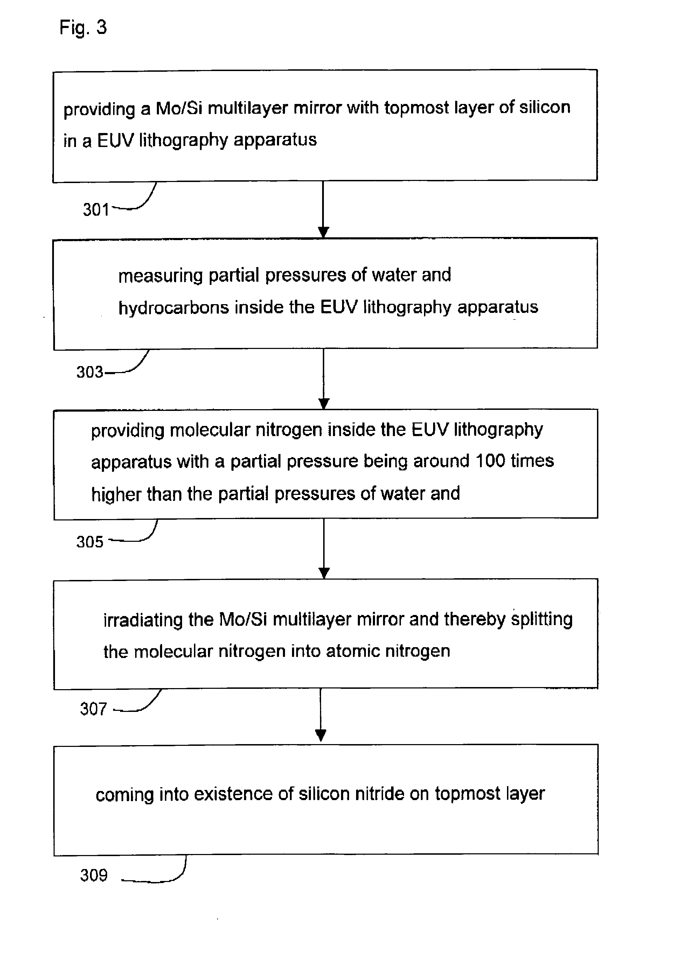

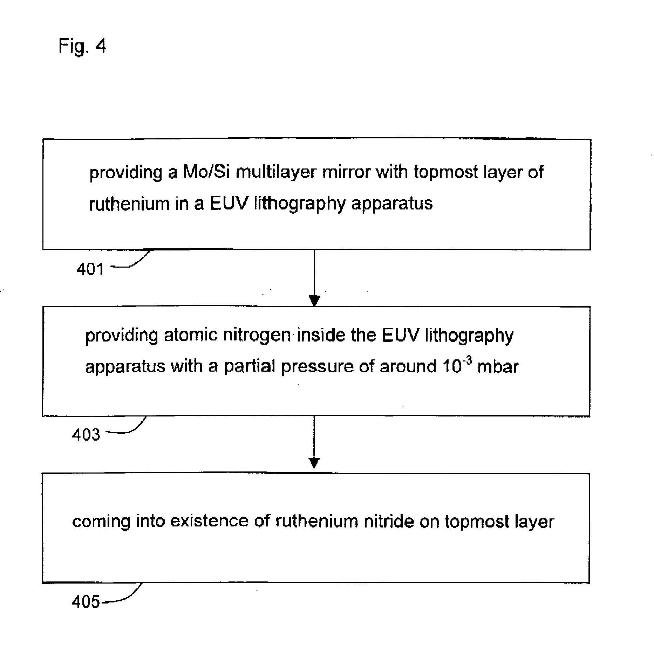

As example, two preferred embodiment of the method for operating a lithography apparatus like that shown in Figure 1 are explained with respect to Figures 3 und 4. According to the first example illustrated in Figure 3, a mirror based on a silicon/molybdenum multilayer structure (see also Figure 2a) is utilized in a EUV lithography apparatus (step 301). Before starting operation of the lithography apparatus, the partial pressures of water and hydrocarbons inside the apparatus are measured (step 303). If the lithography apparatus comprises different modules such as an illumination system and a projection system, the partial pressures are measured inside the module, in which the mirror or eventually mirrors are arranged. The partial pressures of the residual gases vary depending on the quality of the vacuum. E.g. for a typical not heated vacuum, the partial pressure of hydrocarbons is around 10⁻⁸ mbar and the partial pressure of water is around 10⁻⁷ mbar. In a heated vacuum, the partial pressure of hydrocarbons is around 10⁻¹² mbar, while the partial pressure of water is around 10⁻¹¹ mbar. The partial pressure for nitrogen should be ca. a factor 10 higher than the higher partial pressure of the residual gas, here of water, to successfully compete for space on the surface of the mirror and react to volatile nitrogen oxides after splitting into atomic nitrogen. Even better effects can be reached by working with nitrogen partial pressures being e.g. a factor of around 100 or higher (step 305). Theoretically, the partial pressure could be raised to up to 1 mbar, before the loss of EUV radiation due to absorption becomes intolerable. A partial pressure of nitrogen of ca. 10⁻⁶ mbar or higher, preferably of ca. 10⁻⁴ mbar or higher, most preferably of ca. 10⁻³ mbar or higher, in particular for high partial pressures of water (partial pressures as high as 10⁻⁵ mbar and higher might happen), is provided.

By starting operation of the lithography apparatus and, thus, irradiating the mirror, the molecular nitrogen supplied to the atmosphere environing the mirror is split into atomic nitrogen (step 307). Atomic nitrogen is much more reactive than molecular nitrogen. Therefore, it not only successfully competes for space on the silicon topmost layer of the mirror, up to achieving a continuous coverage of the surface. It also reacts with the oxygen in the atmosphere due to water dissociated by EUV radiation and eventually due to residual molecular oxygen in the atmosphere to volatile nitrogen oxides that are innocuous for the mirror surface. As silicon is a material that reacts with atomic nitrogen to silicon nitride, a further positive effect is achieved compared to materials that are relatively inert to atomic nitrogen: A thin film of silicon nitride comes into existence on the surface of the silicon topmost layer of the mirror (step 309). Silicon nitride is resistant against oxidation and has a lower adsorption rate for hydrocarbons than silicon, while it only slightly diffuses inside the topmost layer of silicon and has a complex refractive index in the EUV range such that the optical characteristics of the mirror are only minimally affected. This possible slight degradation is fully counterweighted by the fact that the time life of the mirror is substantially prolonged by efficiently reducing surface damage due to oxidation and carbon contamination.

The nitrogen should advantageously be provided inside the lithography apparatus before starting operation or as soon as possible after starting operation before considerable surface damage at the topmost layer of the mirror has taken place. The partial pressures of the nitrogen as well the residual gases like water and hydrocarbons to name the most noxious, others being e.g. carbon monoxide and carbon dioxide, can be monitored and the partial pressure of nitrogen adjusted throughout the complete operation cycle of the EUV lithography apparatus. In case of the topmost layer of the reflective optical element utilized being of a material that reacts to nitride with the atomic nitrogen, the nitrogen partial pressure might be lowered after the continuous nitride film can be expected to have formed. The nitrogen might also be provided at the beginning of the cycle without further monitoring. This depends on the tolerances of the lithography process and the actual lithography apparatus. In case of a reflective optical element based on a multilayer system with a topmost layer of silicon, nitrogen should most advantageously be supplied during the entire exposure to continuously keep a certain balance between atomic nitrogen and oxygen radicals at the surface of the reflective optical element to most efficiently prevent oxidation of silicon and diffusion of oxygen radicals inside the multilayer system.

Figure 4 illustrates a second preferred embodiment of the method of operating a EUV lithography apparatus. In the present example, a mirror based on a silicon/molybdenum multilayer structure with a capping layer of ruthenium (see also Figure 2b) is used in the EUV lithography apparatus (step 401). Atomic nitrogen is provided, for example from a plasma source. To simplify the process, in case the tolerances allow for it, a quite high partial pressure of atomic nitrogen of ca. 10⁻³ mbar is provided (step 403), without taking into account the actual partial pressures of residual gases inside the lithography apparatus. 10⁻³ mbar is a partial pressure ensuring efficient oxidation and contamination suppression even for higher partial pressures of residual gases without leading to noticeable absorption of EUV radiation. Besides, the positive effects like physisorption on the ruthenium surface, reaction to volatile nitrogen oxides, and reaction to ruthenium nitride on the mirror surface (step 405), as ruthenium is a material that reacts to nitride with atomic nitrogen, take place immediately after placing the mirror inside the apparatus and providing the atomic nitrogen in the surrounding atmosphere, without having to wait for the EUV radiation to split molecular nitrogen into atomic nitrogen.

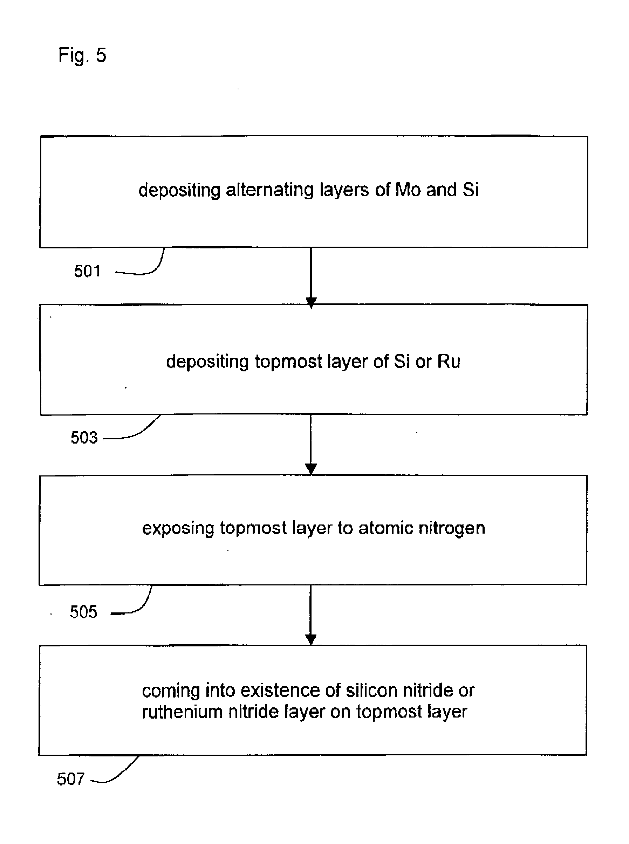

This fact has been utilized to produce reflective optical elements that are more resistant against surface damage from the beginning. A preferred embodiment of the production method for a mirror based exemplary on a silicon/molybdenum multilayer structure for the EUV wavelength range is illustrated in Figure 5. In a first step 501, alternating layers of silicon and molybdenum are deposited on a substrate using the usual deposition techniques. After a topmost layer of silicon or ruthenium has been deposited (step 503), the surface of the topmost layer is exposed to atomic nitrogen (step 505) diffusing out of a RF plasma source, like e.g. an electron cyclotron wave resonance source. If such a source is tuned such that the extracted ions have energies below the sputtering threshold of around 50 eV, than no harm is caused to the surface of the topmost layer, while the atomic nitrogen reacts with the silicon or the ruthenium to a thin silicon nitride or ruthenium nitride film on the surface of the topmost layer of silicon or ruthenium respectively. This nitride film protects the surface of the mirror in particular from oxidization. During operation of a lithography apparatus with such a mirror, the protection effect can be enhanced by providing atomic nitrogen in the surrounding atmosphere to cover the surface and react with oxygen to volatile nitrogen oxides.

### List of reference numerals

- 1: reflective optical element
- 2: multilayer system
- 3: substrate
- 4: capping layer
- 5,5': nitride layer
- 20: periodic stack
- 21: material with higher real part of the complex refraction index
- 22: material with lower real part of the complex refraction index
- 100: EUV lithography apparatus
- 110: beam shaping system
- 111: EUV source
- 112: collimator
- 113: monochromator
- 120: illumination system
- 121, 122: mirror
- 123: N₂ inlet
- 124: partial pressure measuring module
- 130: reticle
- 140: projection system
- 141, 142: mirror
- 143: plasma source with N inlet
- 144: partial pressure measuring module
- 150: wafer
- 301-309: step of process
- 401-405: step of process
- 501-507: step of process

## Claims

1. A method for operating a lithography apparatus (100) for the extreme ultraviolet or soft x-ray wavelength range having a reflective optical element for the extreme ultraviolet or soft x-ray wavelength range, **characterized in that** at least adjacent to the reflective optical element (1, 112, 113, 121, 122, 130, 141, 142) an atmosphere containing atomic nitrogen is provided.

2. The method according to claim 1, **characterized in that** the atmosphere containing atomic nitrogen is provided during irradiation of the reflective optical element (1, 112, 113, 121, 122, 130, 141, 142).

3. The method according to claim 1 or 2, **characterized by** comprising the steps:
- providing an atmosphere containing molecular nitrogen at least adjacent to the reflective optical element (1, 112, 113, 121, 122, 130, 141, 142), the partial pressure of molecular nitrogen being higher than the partial pressure of other components of the atmosphere;
- irradiating the reflective optical element (1, 112, 113, 121, 122, 130, 141, 142) with extreme ultraviolet or soft x-ray radiation.

4. The method according to claim 3, **characterized by** further comprising the steps:
- measuring the partial pressures of molecular nitrogen and other components inside the lithography apparatus (100);
- providing a partial pressure of molecular nitrogen being a factor of around 10 or higher than the measured partial pressures of the components other than nitrogen.

5. The method according to claim 4, **characterized in that** the partial pressures of water and/or hydrocarbons are measured.

6. The method according to any of claims 3 to 5, **characterized in that** a partial pressure of molecular nitrogen of ca. 10⁻⁶ mbar or higher, preferably of ca. 10⁻⁴ mbar or higher, most preferably of ca. 10⁻³ mbar or higher is provided.

7. The method according to any of claims 1 to 6, **characterized in that** the amount per time of atomic nitrogen at least adjacent to the reflective optical element (1, 112, 113, 121, 122, 130, 141, 142) is higher than the amount per time of oxygen radicals.

8. The method according to any of claims 1 to 7, **characterized in that** the reflective optical element (1, 112, 113, 121, 122, 130, 141, 142) has a multilayer structure (2), the top layer (21, 4) of which comprises a material that reacts with atomic nitrogen to a nitride.

9. A method for producing a reflective optical element for the extreme ultraviolet or soft x-ray wavelength range having a multilayer structure, **characterized in that** after depositing the topmost layer (21, 4), the reflective optical element (1, 112, 113, 121, 122, 130, 141, 142) is exposed to an atmosphere containing atomic nitrogen.

10. The method according to claim 9, **characterized in that** a topmost layer (21, 4) is deposited that comprises a material that reacts with atomic nitrogen to a nitride.

11. The method according to claim 9 or 10, **characterized in that** a topmost layer (21, 4) is deposited comprising a material of the group silicon and ruthenium.

12. A lithography apparatus (100) for the extreme ultraviolet or soft x-ray wavelength range having a reflective optical element (1, 112, 113, 121, 122, 130, 141, 142) for the extreme ultraviolet or soft x-ray wavelength range, **characterized in that** it comprises a plasma source (143), in particular for providing atomic nitrogen.

13. The lithography apparatus according to claim 12, **characterized in that** it comprises means (124, 144) for measuring the partial pressure of components of the atmosphere inside the apparatus (100).

14. The lithography apparatus according to claim 12 or 13, **characterized in that** it comprises a nitrogen inlet (123).

15. An illumination system (120) for a lithography apparatus (100) for the extreme ultraviolet or soft x-ray wavelength range having a reflective optical element (121, 122) for the extreme ultraviolet or soft x-ray wavelength range, **characterized in that** it comprises a plasma source (143), in particular for providing atomic nitrogen.

16. A projection system (140) for a lithography apparatus (100) for the extreme ultraviolet or soft x-ray wavelength range having a reflective optical element (141, 142) for the extreme ultraviolet or soft x-ray wavelength range, **characterized in that** it comprises a plasma source (143), in particular for providing atomic nitrogen.
